# DEMANDE DE BREVET EUROPEEN

(11) **EP 4 790 168 A1**
(43) Date de publication de la demande: **12.08.2026**
(21) Numéro de dépôt: 25290008.9
(22) Date de dépôt: 06.02.2025
(51) Int. Cl.: C23C 16/30, C08J 7/043, C08J 7/048, C23C 16/32, C23C 16/36, C23C 16/40, C23C 16/455, C23C 16/54, B05D 1/00

(54) **PROCÉDÉ DE TRAITEMENT D'UN FILM PLASTIQUE PAR PLASMA ATMOSPHÉRIQUE AFIN D'AMÉLIORER SON ADHÉRENCE À UN ÉLASTOMÈRE**

(71) Demandeur: Coating Plasma Innovation, 13710 Fuveau (FR)
(72) Inventeur: Jellid, Jihed, 13710 Fuveau (FR); Vandencasteele, Nicolas, 13100 Saint-Marc-Jaumegarde (FR)
(74) Mandataire: Calysta NV

(57) **Abrégé**

L'invention concerne un procédé de traitement d'un film plastique, comprenant une étape de dépôt, à pression atmosphérique, d'une couche mince sur le film défilant à une vitesse V, par exposition à un plasma froid généré avec une puissance P dans une atmosphère gazeuse comprenant un gaz plasmagène et un précurseur volatil de silicium introduit avec un débit massique D ; dans lequel le précurseur est choisi parmi les alkoxysilanes et les alkoxy-aminosilanes et leurs mélanges ; et en ce que le rapport R défini par R = [(V x dP) / D] est compris entre 150 000 et 2 800 000 W.m-¹.g⁻¹.

## Description

### Domaine technique

La présente invention s'inscrit dans le domaine des films plastiques.

Dans ce contexte, la présente invention propose une procédé de traitement de tels films plastiques de manière à leur conférer d'excellentes propriétés d'adhérence à un élastomère ou caoutchouc, après leur laminage.

La présente invention propose également un film plastique obtenu par ledit procédé, un composite élastomère/film plastique ainsi que son utilisation avantageuse dans le domaine médical ou pharmaceutique, notamment en tant que produit de scellement ou bouchon ou septum de flacons ou en tant que piston de seringue, ou encore dans un domaine plus général, en tant que joint.

### Art antérieur

Les produits pharmaceutiques, notamment liquides, y compris les vaccins, sont généralement transportés et conservés dans des récipients (flacons, fioles, bouteilles, poches, etc.) scellés grâce à un bouchon en caoutchouc agissant souvent comme septum permettant, au moment de l'administration du produit à un patient, d'être percé avec une aiguille ou une ou plusieurs fois (application multidose). Ces bouchons doivent évidemment répondre aux exigences strictes et normées de l'industrie pharmaceutique. Des caoutchoucs, aussi appelé couramment élastomères, connus pour fabriquer de tels bouchons à usage médical ou pharmaceutique sont souvent du type bromo-butyl ou fluoro-butyl.

De manière générale, un bouchon à usage médical ou pharmaceutique doit garantir la sécurité et l'efficacité du produit contenu dans le récipient en évitant toute contamination et dégradation dudit produit. Il doit ainsi offrir une totale étanchéité/intégrité de la fermeture du récipient (capacité à protéger le produit du milieu extérieur), une excellent inertie chimique et un maintien de la stabilité du produit.

De plus, il doit montrer de bonnes propriétés de pénétrabilité (force nécessaire pour le pénétrer avec une aiguille), de fragmentation (nombre de fragments de caoutchouc libérés dans le récipient lors de la pénétration de l'aiguille, critère essentiel) et d'auto-obturation pour les bouchons multi-usages (capacité à refermer l'étanchéité après plusieurs pénétrations d'aiguille).

Finalement, il doit résister mécaniquement aux températures très basses nécessaires au stockage de certains produits pharmaceutiques comme des vaccins (par ex. les vaccins du type ARN qui nécessitent des températures de conservation de -80°C) et également être compatible avec la stérilisation (autoclave ou irradiation gamma).

Afin de réduire la contamination (ou « leaching ») de composés/éléments de l'élastomère dans le produit pharmaceutique ainsi que le phénomène d'adsorption dudit produit dans l'élastomère lui-même, il a été proposé de recouvrir un bouchon en caoutchouc par un film d'ETFE (ou éthylène tétrafluoroéthylène). En effet, du fait de son inertie chimique, de son hydrophobicité et de sa faible énergie de surface, l'ETFE agit comme une barrière qui protège le produit pharmaceutique de la contamination en minimisant l'interaction entre le médicament et le bouchon tout en maintenant l'intégrité de la fermeture du récipient. Un tel film est connu de l'état de la technique, notamment sous le nom de FluroTec^{®}, pour son utilisation en combinaison avec des bouchons en bromo-butyl ou en fluoro-butyl. De tels bouchons sont décrits comme résistants à des températures jusqu'à -80°C et peuvent donc être utilisés pour fermer des flacons contenant un vaccin SARS-CoV-2. Le composite (bouchon en caoutchouc recouvert d'un film d'ETFE) est obtenu par laminage, notamment à chaud.

Toutefois, l'adhérence d'un tel film d'ETFE est relativement faible sur un élastomère en général. Par exemple, la force de pelage d'un film d'ETFE laminé sur un caoutchouc de type halo-butyl est de l'ordre de 4N/25mm, ce qui n'est pas acceptable pour garantir/maintenir les exigences de l'industrie pharmaceutique. Cette force de pelage est même plus faible encore pour (i) d'autres type de films plastiques, notamment halogénés et/ou (ii) d'autres types d'élastomères (par exemple, l'EPDM ou « éthylène-propylène-diène monomère »), d'intérêt dans d'autres domaines.

Ainsi, il serait d'un intérêt tout particulier de disposer d'un film plastique qui montrerait une excellente adhérence des matières élastomères en général, notamment après leur laminage/pressage, et qui, une fois recouvrant cette matière (sous forme de bouchons ou de pistons de seringue), garantit/maintient les exigences strictes requises par l'industrie pharmaceutique (inertie chimique, absence de contamination, étanchéité, résistance à des basses températures, comptabilité avec la stérilisation, etc.).

### Objectifs de l'invention

Un objectif de la présente invention est de surmonter les inconvénients de l'état de la technique, notamment ceux décrits ci-dessus.

En particulier, un objectif de la présente invention est de fournir un procédé de traitement d'un film plastique afin de lui conférer une excellente adhérence à une matière élastomère.

Un autre objectif de la présente invention est de fournir un procédé de traitement d'un film plastique afin de lui conférer une excellente adhérence à une matière élastomère qui est stable dans le temps.

Un autre objectif de la présente invention est de fournir un procédé de traitement d'un film plastique qui conservent les autres propriétés intrinsèques (chimiques, physiques) de ladite matière élastomère.

Un autre objectif de la présente invention est de fournir un procédé de traitement d'un film plastique qui garantit/maintient les exigences strictes requises par l'industrie pharmaceutique lorsqu'il est laminé sur une matière élastomère, par exemple, un bouchon ou un piston de seringue.

Finalement, encore un autre objectif de la présente invention est de fournir un procédé de traitement d'un film plastique qui est rapide et économiquement intéressant.

### Description de l'invention

Pour atteindre les objectifs précités, il est prévu selon l'invention un procédé de traitement d'un film plastique présentant une première surface et une deuxième surface, ledit procédé comprenant une étape de dépôt, dans une enceinte à pression atmosphérique, d'une couche mince sur la première surface du film en défilement à une vitesse V, le dépôt étant réalisé par exposition de ladite première surface à un plasma froid dans une atmosphère gazeuse comprenant un gaz plasmagène et au moins un précurseur volatil de silicium, le plasma étant généré avec une densité de puissance dP et ledit au moins un précurseur volatil de silicium étant introduit dans l'enceinte durant l'étape de dépôt avec un débit massique D ; procédé dans lequel ledit au moins un précurseur volatil de silicium est choisi parmi les alkoxysilanes et les alkoxy-aminosilanes et leurs mélanges ; et le rapport R défini par R = [(V x dP) / D] est compris entre 150 000 et 2 800 000 W.m⁻¹.g⁻¹.

L'invention est ainsi basée sur une approche nouvelle et inventive. En effet, les inventeurs ont constaté, de manière surprenante, que la combinaison des paramètres spécifiques du procédé plasma de l'invention, plus précisément (i) un précurseur particulier et (ii) le respect d'une relation spécifique entre vitesse de défilement du film, densité de puissance du plasma et débit du précurseur, permet d'atteindre les objectifs précités. Ainsi, en particulier, en suivant le procédé de l'invention, on obtient un film plastique dont les propriétés d'adhésion sur un élastomère sont grandement améliorées et sont stables dans le temps, tout en conservant les autres propriétés intrinsèques (chimiques, physiques) de l'élastomère en lui-même.

Les inventeurs ont découvert que le procédé de l'invention permettait d'augmenter l'adhérence des films plastiques en général sur de nombreux types d'élastomère. Le procédé de l'invention peut ainsi être utilisé pour fabriquer des films plastiques utiles en combinaison avec un élastomère, pour de nombreuses applications.

Par exemple, il peut être utilisé très avantageusement pour fabriquer un film, par exemple d'ETFE, qui montre alors une adhérence significativement augmentée sur un élastomère (par exemple, un halo-butyl) après leur laminage, et qui, une fois recouvrant cette matière (sous forme de bouchons ou de pistons de seringue), garantit/maintient les exigences strictes requises par l'industrie pharmaceutique (inertie chimique, absence de contamination, étanchéité, résistance à des basses températures, comptabilité avec la stérilisation, etc.).

A titre d'autre exemple, le procédé de l'invention permet également avantageusement de traiter un film de PEEK (sigle commun du polyétheréthercétone) qui peut ensuite être combiné, par laminage, et avec une excellente adhérence, à un élastomère du type EPDM (pour « éthylène-propylène-diène monomère ») qui est un caoutchouc standard utilisé couramment pour des joints mais avec une faible résistance chimique aux huiles, essences et hydrocarbures. Le composite ainsi obtenu possède les avantages de ce caoutchouc standard (par exemple, en terme de coût) mais montre une excellente résistance chimique à sa surface du fait qu'il est recouvert d'un film de PEEK. Il peut ainsi trouver un grand intérêt dans le domaine automobile (et domaines associés) notamment, en remplacement du matériau appelé Viton^{®} couramment utilisé jusqu'ici mais que les constructeurs automobiles cherchent de plus en plus à limiter, voire à supprimer. En effet, ce matériau rentre dans la classe de produits chimiques appelés « PFAS » (ou substances per- et polyfluoroalkylées) qui sont néfastes du fait de leur persistance dans l'environnement en raison de la solidité des liaisons carbone-fluor qu'ils contiennent et ayant des effets délétères pour l'être humain.

L'invention concerne également un film plastique, susceptible d'être obtenu par le procédé de l'invention.

L'invention concerne également un procédé de fabrication d'un composite, comprenant une étape de laminage, notamment à chaud, d'un élastomère avec un film plastique selon l'invention ou obtenu par le procédé selon l'invention.

L'invention concerne également un composite constitué d'un élastomère recouvert au moins partiellement d'un film plastique selon l'invention ou obtenu par le procédé selon l'invention, montrant une force de pelage dudit film sur ledit élastomère supérieure à 20 N/25mm.

Finalement, l'invention concerne également l'utilisation d'un film plastique selon l'invention ou obtenu par le procédé selon l'invention ou d'un composite selon l'invention :
- dans le domaine médical ou pharmaceutique, notamment en tant que produit de scellement ou bouchon ou piston de seringue; ou
- dans un joint, notamment de type torique.

D'autres caractéristiques, détails et avantages de l'invention ressortiront de la description ci-après.

Dans la présente description et les revendications, il est bien entendu que les termes « un », « une » ou « le » signifient « au moins un » et ne doivent pas être limités à « un seul », sauf indication contraire explicite, De plus, lorsqu'une plage de valeur est indiquée, les extrémités sont incluses. Finalement, toutes les valeurs intégrales et de sous-domaine dans une gamme/plage numérique sont expressément incluses comme si explicitement écrites.

Par souci de clarté, la vitesse V selon l'invention est exprimée en m.min⁻¹ (m/min ou mètre par minute), la densité de puissance dP est exprimée en W.m⁻² (ou W/m² ou watt par mètre carré), et le débit massique D est exprimé en g.min⁻¹ (ou g/min ou gramme par minute).

Le film plastique selon l'invention présente une première surface et une deuxième surface, la première surface étant celle qui est traitée selon le procédé de l'invention par exposition au plasma. Le film plastique selon l'invention peut avoir des dimensions variables, celles communément considérées dans l'application visée et en particulier celles accessibles au dispositif utilisé pour implémenter le procédé. En particulier, le procédé de l'invention permet de traiter un film possédant une grande largeur, par exemple 2 mètres ou même au-delà. De plus, le film plastique de l'invention peut avoir une épaisseur de quelques microns et jusqu'à quelques millimètres, par exemple de 4 microns à 2 mm.

Le film plastique de l'invention peut être fait de tout plastique utile à être combiné, par laminage, à un matériau du type élastomère, et notamment présentant une adhérence insatisfaisant audit matériau. Le film plastique peut ainsi être en une matière choisie dans le groupe constitué des polymères halogénés, des polyoléfines, des polyesters, des polymères du type polysulfone, des polymères du type polyimide (PI) et de leurs dérivés.

Selon un mode de réalisation avantageux de l'invention, le film plastique est fait d'un polymère halogéné, en particulier fluoré ou chloré. De préférence, le film plastique est fait d'un polymère fluoré. Selon ce mode de réalisation, de préférence et notamment pour des applications médicales ou pharmaceutiques, le film plastique est en ETFE (éthylène tétrafluoroéthylène) ou en PTFE (propylène tétrafluoroéthylène) ou en FEP (éthylène-propylène fluoré) ou en PVDF (fluorure de polyvinylidène).

Selon un autre mode de réalisation avantageux de l'invention, le film plastique est fait d'un polymère du type polyaryléthercétones (PAEK). Selon ce mode de réalisation, de préférence, le film plastique est fait de PEEK.

Selon encore un autre mode de réalisation avantageux de l'invention, le film plastique est fait d'un polymère du type polysulfone, par exemple, de PPSU (polyphénylsulfone).

Selon encore un autre mode de réalisation avantageux de l'invention, le film plastique est fait d'un polyester, par exemple, de PET (polyéthylène téréphtalate).

Le film traité/obtenu selon le procédé selon l'invention possède avantageusement une meilleure adhérence à un élastomère d'intérêt après son laminage sur ledit élastomère. En particulier, le film plastique montre une force de pelage significativement augmentée par rapport à celle du film plastique de départ (avant le traitement selon l'invention). Par exemple, ledit film, après son laminage/pressage sur un élastomère, notamment à chaud, montre une force de pelage sur ledit élastomère supérieure à 20 N/25mm, de préférence supérieure à 30 N/25mm, voire supérieure à 40 N/25mm. Il est entendu que le laminage se fait avec la première surface (celle traitée selon l'invention) en contact avec l'élastomère. La force de pelage du film obtenu selon le procédé de l'invention est mesurée après son laminage/pressage à chaud) sur l'élastomère cru (ou non vulcanisé), à une pression de 5.6 MPa et à une température et sur une durée qui sont fonction dudit élastomère (par ex., entre 60 et 180°C). La force de pelage du film obtenu selon le procédé de l'invention est mesurée sur des échantillons de produits laminés (film-caoutchouc) découpés en bande de 25 mm de large, avec un appareil AR1000 (Cheminstrument) pendant le pelage se faisant à un angle de 180° et avec une vitesse d de 300 mm/min. Le capteur de force de l'appareil peut mesurer des forces jusqu'à 50 N.

Selon l'invention, le procédé comprend une étape de dépôt, dans une enceinte à pression atmosphérique, d'une couche mince sur la première surface du film.

L'expression « à pression atmosphérique » selon l'invention se rapporte au domaine lié, en particulier le domaine du traitement/dépôt par plasma, et est parfaitement compris de la personne du métier. En particulier, elle inclut également une pression proche de la pression atmosphérique, c'est-à-dire une pression qui s'écarte de la pression atmosphérique par une différence de pression (positive ou négative) qui ne dépasse pas quelques dizaines ou une ou deux centaine(s) de Pa. Plus précisément, la pression s'écarte de la pression atmosphérique au plus de ± 100 Pa.

Dans la présente description et les revendications, le terme « couche mince » se rapporte au domaine lié, en particulier le domaine du traitement/dépôt par plasma, et est parfaitement compris de la personne du métier.

Selon l'invention, l'étape dépôt de la couche mince se fait sur la première surface du film qui est en défilement dans l'enceinte à une vitesse V définie. Avantageusement, la vitesse de défilement V du film à l'étape de dépôt est supérieure à 20, 30, 40 ou 50 m/min, de préférence supérieure à 60 m/min, voire supérieure à 80 m/min. Avantageusement également, la vitesse de défilement V du film à l'étape de dépôt est inférieure à 200 m/min, de préférence inférieure à 150 m/min, voire inférieure à 120 m/min.

Toujours selon l'invention, dans l'enceinte, le dépôt de la couche mince est réalisé par exposition de la première surface du film à un plasma froid, généré avec une densité de puissance dP, dans une atmosphère gazeuse comprenant un gaz plasmagène et au moins un précurseur volatil de silicium.

Par « plasma froid » selon l'invention, on entend la définition communément admise dans le domaine et clairement comprise par l'homme du métier (et par opposition au plasma « chaud » ou « thermique », qui ont des températures très élevées, pouvant aller jusqu'à plusieurs milliers de degrés centigrades, et utilisés par exemple pour découper ou souder des pièces métalliques).

Selon un mode de réalisation préféré de l'invention, ledit plasma froid selon l'invention est formé par décharge contrôlée par barrière diélectrique (DBD ou « Dielectric Barrier Discharge), technique connue en tant que telle pour générer un plasma au départ d'un gaz plasmagène. Selon ce mode, de manière avantageuse, l'espacement entre la surface active des électrodes utilisée pour produire la décharge contrôlée par barrière diélectrique et le film en défilement peut être réglé, notamment pour assurer la stabilité et l'homogénéité du plasma. A titre d'exemple, la distance entre le film et la surface active des électrodes peut être réglé entre 1 et 2 mm.

Communément, les électrodes sont reliées à un générateur HV basse fréquence (typiquement une à quelques centaines de kHz) et de puissance variable (en W/m², l'unité de surface se référant à la surface cumulée des électrodes).

Selon l'invention et de manière connue dans le domaine, la densité de puissance dP (exprimée en W/m²) correspond à la puissance électrique totale dissipée par le générateur plasma dans la décharge par unité de surface cumulée des électrodes. Par exemple, la densité de puissance dP est comprise entre 10 000 et 41 000 W/m².

Selon un mode de réalisation particulier de l'invention, l'exposition est réalisée à une température inférieure à 100°C, notamment en maintenant l'enceinte et/ou le film au sein de l'enceinte à une température inférieure à 100 °C.

Selon l'invention, durant l'étape de dépôt, ledit au moins un précurseur volatil de silicium est introduit dans l'enceinte avec un débit massique D. Par exemple, ledit au moins un précurseur volatil de silicium est introduit dans l'enceinte avec un débit massique compris entre 0.25 et 2 g/min, ou entre 0.25 et 1.5 g/min, voire entre 0.25 et 1.25 g/min.

Selon l'invention et de manière connue dans le domaine, ledit au moins un précurseur volatil de silicium est introduit dans l'enceinte sous forme gazeuse. Toujours selon l'invention et de manière connue dans le domaine, ledit au moins un précurseur volatil de silicium est introduit dans l'enceinte sous forme gazeuse en présence d'un gaz vecteur, typiquement de l'azote.

Selon l'invention, l'atmosphère gazeuse dans l'enceinte comprend un gaz plasmagène et au moins un précurseur volatil de silicium.

Avantageusement, le gaz plasmagène est choisi dans le groupe constitué des gaz nobles, de l'azote et leurs mélanges. De manière préférée, le gaz plasmagène est choisi dans le groupe constitué de l'argon, l'azote et leur mélange. L'azote est tout particulièrement préféré. De préférence également, l'atmosphère gazeuse peut comprendre au moins un autre gaz choisi dans le groupe constitué de N₂O, O₂, CO₂, H₂, éthylène, air et leurs mélanges.

Selon l'invention, ledit au moins un précurseur volatil de silicium est choisi parmi les alkoxysilanes, les alkoxy-aminosilanes et leurs mélanges. Par « alkoxy-silane », on entend un silane possédant quatre groupes alkoxy, -OR. Par « alkoxy-aminosilane », on entend un silane bifonctionnel possédant un groupe amine, en particulier amine primaire -R-NH₂, et trois groupes alkoxy, -OR.

De préférence, ledit au moins un précurseur volatil de silicium est choisi parmi les alkoxy-aminosilanes, en particulier les alkoxy-aminosilanes de formule Si(O(CH₂)ₓCH₃)₃((CH₂)_{y}NH₂) avec x = 1 ; 2 ; 3 ou 4 et y = 1 ; 2 ; 3 ; 4 ou 5. De manière toute préférée, ledit au moins un précurseur volatil de silicium est le (3-aminopropyl)triéthoxysilane (également connu sous l'acronyme APTES) ou le (3-aminopropyl)triméthoxysilane (également connu sous l'acronyme APTMS).

Selon un mode de réalisation particulier, l'atmosphère gazeuse comprend plus d'un précurseur volatil de silicium, par exemple deux ou même trois précurseurs volatils de silicium, potentiellement tous choisis parmi les alkoxysilanes, les alkoxy-aminosilanes et leurs mélanges.

Selon l'invention, le rapport R est défini par la formule R = [(V x P) / D] et est compris entre 150 000 et 2 800 000 W.m⁻¹.g⁻¹ (« x » correspondant à un multiplicateur). De préférence, le rapport R est inférieur ou égal à 2 400 000 W.m⁻¹.g⁻¹, de préférence inférieur ou égal à 2 000 000 W.m⁻¹.g⁻¹ ou mieux, inférieur ou égal à 1 600 000 W.m⁻¹.g⁻¹.

Selon un mode de réalisation de l'invention, la couche mince déposée à l'étape de dépôt comprend au moins les éléments suivants : silicium, carbone et oxygène. En particulier, elle peut être constituée d'une composition du type SiCₓO_{y}. Notamment dans le cas où ledit au moins un précurseur volatil de silicium est choisi parmi les alkoxy-aminosilanes, la couche mince déposée à l'étape de dépôt comprend de l'azote, et est en particulier, constituée d'une composition du type SiCₓO_{y}N_{z}.

Selon un autre mode de réalisation de l'invention, la couche mince déposée à l'étape de dépôt a une épaisseur inférieure à 10 nm, de préférence inférieure à 8 nm, voire inférieure à 5 nm.

Le procédé de l'invention peut comprendre un ou plusieurs autres(s) étape(s), avant, pendant et/ou après l'étape de dépôt selon l'invention. Par exemple, il peut s'agir d'une étape d'activation du film avant le dépôt ou bien d'une étape d'extraction pendant le dépôt de manière à extraire/évacuer le ou les gaz présent(s) dans l'enceinte et/ou d'éventuels sous-produits créés dans le plasma et non valorisé sur le film.

La présente invention concerne également un film plastique susceptible d'être obtenu par le procédé de l'invention, notamment fourni en rouleau. Ce film plastique est particulièrement avantageux car, en plus des propriétés intrinsèques du plastique dont il est fait, il présente une adhérence augmentée sur des matières élastomères en général. En particulier, ledit film plastique de l'invention possède une grande largeur, par exemple 2 mètres ou au-delà. De plus, ledit film plastique peut avoir une épaisseur de quelques microns et jusqu'à quelques millimètres, par exemple de 4 microns à 2 mm.

L'invention concerne un procédé de fabrication d'un composite, comprenant une étape de laminage, notamment à chaud, d'un élastomère avec un film plastique selon l'invention ou obtenu par le procédé de l'invention. Selon ce procédé, de préférence, l'élastomère est cru (non vulcanisé) et l'étape de laminage est faite à chaud, par exemple à une température de l'ordre de 120°C, et comprend une vulcanisation dudit élastomère et un pressage.

Avantageusement, pour des applications médicales ou pharmaceutiques, l'élastomère est un halo-butyl et le film plastique est en ETFE. Dans ce cas, le film montre une excellente adhérence à l'halo-butyl et, une fois recouvrant cet élastomère (sous forme de bouchons ou de pistons de seringue par exemple), garantit/maintient les exigences strictes requises par l'industrie pharmaceutique (inertie chimique, absence de contamination, étanchéité, résistance à des basses températures, compatibilité avec la stérilisation, etc.).

Avantageusement également, pour des applications plus générales, notamment pour des joints par exemple dans le domaine automobile ou pour des pompes, l'élastomère est en EPDM et le film plastique est en PEEK. Dans ce cas, le film montre une excellente adhérence à l'EPDM et, une fois recouvrant cet élastomère (sous forme de joint torique par exemple), garantit une bonne résistance chimique aux huiles, essences et hydrocarbures, tout en ayant les avantages liés à l'EPDM (notamment son faible coût) et en évitant l'utilisation d'une matière classée PFAS (comme le Viton^{®} couramment utilisé pour des joints résistants chimiquement).

L'invention concerne également un composite constitué d'un élastomère recouvert au moins partiellement d'un film plastique selon l'invention ou obtenu par le procédé de l'invention, montrant une force de pelage dudit film sur ledit élastomère supérieure à 30 N/m, de préférence supérieure à 40 N/m.

Finalement, l'invention concerne également l'utilisation d'un film plastique selon l'invention ou obtenu par le procédé selon l'invention ou d'un composite selon l'invention :
- dans le domaine médical ou pharmaceutique, notamment en tant que produit de scellement ou bouchon ou piston de seringue; ou
- dans un joint (par exemple de type torique), notamment utilisable dans le domaine automobile ou pour toute autre application appropriée (par exemple, dans une pompe).

Il est bien entendu que la présente invention n'est en aucune façon limitée aux formes de réalisations décrites ci-dessus et que des modifications peuvent y être apportées sans sortir du cadre des revendications. Il est en outre entendu que l'invention englobe également toutes les combinaisons possibles de caractéristiques et de caractéristiques préférées, décrites ici et citées dans les revendications.

De plus, les exemples suivants sont fournis à des fins d'illustration et ne sont pas destinés à limiter la portée de la présente invention.

### Exemples

### Exemple 1 :

On a réalisé un traitement d'un film plastique en ETFE (épaisseur : 0,1 mm) selon le procédé de l'invention, en utilisant une installation « roll-to-roll » (rouleau de largeur 600 mm) et un enceinte plasma du type DBD, en utilisant le précurseur de silicium APTES et en faisant varier le rapport R de manière à obtenir des exemples selon l'invention (dans la gamme de valeurs revendiquée) et des exemples comparatifs. L'espacement entre le film et la surface active des électrodes a été réglé à environ 1 mm. Les conditions utilisées sont reprises dans le tableau 1 ci-dessous.

**Tableau 1**

| **Condition** | **Vitesse (m/min)** | **Densité de Puissance (W/m²) *** | **Débit (g/min)** | **R (W.m⁻¹.g⁻¹)** |
|---|---|---|---|---|
| Condition 1 (inv) | 25 | 10158.7 | 1.17 | 217687.1 |
| Condition 2 (inv) | 50 | 20317.5 | 1.17 | 870748.3 |
| Condition 3 (comp) | 100 | 40634.9 | 1.17 | 3482993.2 |
| Condition 4 (comp) | 150 | 40634.9 | 1.17 | 5224489.8 |
| Condition 5 (inv) | 80 | 18571.4 | 1.17 | 1273469.4 |
| Condition 6 (inv) | 100 | 10634.9 | 0.83 | 1276190.5 |
| Condition 7 (inv) | 50 | 10634.9 | 0.33 | 1595238.1 |
| Condition 8 (inv) | 80 | 18571.4 | 1.17 | 1273469.4 |
| Condition 9 (inv) | 100 | 18571.4 | 1.17 | 1591836.7 |
| Condition 10 (inv) | 50 | 18571.4 | 1.17 | 795918.4 |
| Condition 11 (inv) | 20 | 18571.4 | 1.17 | 318367.3 |
| Condition 12 (inv) | 10 | 18571.4 | 1.17 | 159183.7 |
| Condition 13 (comp) | 200 | 18571.4 | 1.17 | 3183673.5 |
| Condition 14 (inv) | 80 | 18571.4 | 0.83 | 1782857.1 |
| Condition 15 (inv) | 100 | 18571.4 | 0.83 | 2228571.4 |
| Condition 17 (inv) | 20 | 18571.4 | 0.83 | 445714.3 |
| Condition 18 (inv) | 10 | 18571.4 | 0.83 | 222857.1 |
| Condition 19 (comp) | 200 | 18571.4 | 0.83 | 4457142.9 |

| | | | | |
|---|---|---|---|---|
| *surface cumulée des électrodes : 0,126 m² | | | | |

Pour chacune des valeurs de R, le film obtenu après traitement a été évalué quant à son adhérence sur un élastomère du type bromo-butyl. A cet effet, un morceau de bromobutyl cru est placé entre 2 échantillons du film traité et l'assemblage est pressé pendant 6 minutes à 5,6 MPa entre 2 blocs chauffés à 80°C. Ensuite, sur l'assemblage obtenu et découpé en une bande de 25 mm de large, la force de pelage du film a été déterminée avec un appareil AR1000 (Cheminstrument) pendant un pelage se faisant à un angle de 180° et avec une vitesse de 300 mm/min (le capteur de force de l'appareil peut mesurer des forces jusqu'à 50 N). La valeur du film sans traitement a également été évaluée et est de 4 N/25mm.

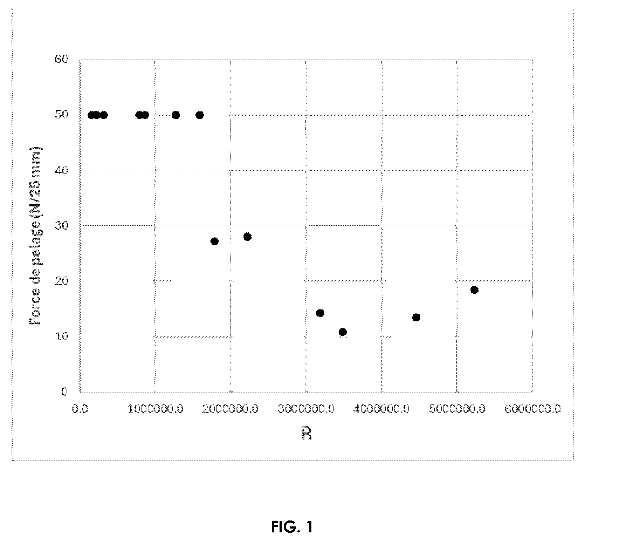

Les résultats de forces de pelage sont montrés à la Fig.1. Elle montre clairement que les exemples selon l'invention présentent une force de pelage significativement augmentée (forces de pelage toutes supérieures à 28 N/25mm et même proches de 50 N/25 mm pour certains films) par rapport au film avant traitement et par rapport aux exemples comparatifs (forces de pelage entre 10 et 18 N/25 mm).

De plus, certains films selon l'invention ont été analysés par spectrométrie de photoélectrons induits par rayons X ou XPS, du côté de la surface traitée. Les pourcentages atomiques des éléments F, O, N, C, Si ont été déterminés à partir de spectres de survol avec un appareil de type Nova-Kratos^{™} avec une source Al-Kα monochromatisée (225 W) sur une aire de 300 m x 700 pm en détection normale (angle de détection θ = 0°). Les résultats montrent que la surface du film traité selon l'invention (profondeur d'analyse < 10 nm) présente les éléments C, Si, N , O et F en quantité significative. La détection d'un signal significatif du fluor provenant du film plastique montre que la couche déposée présente une épaisseur faible, en particulier inférieur à la profondeur d'analyse (10 nm). Une estimation basée sur l'analyse de l'atténuation du signal du fluor montre une épaisseur de la couche entre 1 et 6 nm.

### Exemple 2 :

On a réalisé un traitement de différents types de films plastiques selon le procédé de l'invention, en utilisant une installation «roll-to-roll » (rouleau de largeur 600 mm) et un enceinte plasma du type DBD, en utilisant le précurseur de silicium APTES et les conditions 1 à 7 données à l'exemple 1 dans le Tableau 1. L'espacement entre le film et la surface active des électrodes a été réglé à environ 1 mm.

Les films plastiques utilisés dans cet exemple sont repris dans le tableau 2, avec leur référence et leur épaisseur.

**Tableau 2**

| **Film** | **Epaisseurs (microns)** |
|---|---|
| PET | 50 |
| ETFE | 100 |
| PI | 25 |
| PEEK | 25 |
| FEP | 100 |
| PVDF | 60 |

Chaque film obtenu après traitement a été évalué quant à son adhérence sur un élastomère du type bromo-butyl. A cet effet, un morceau de bromo-butyl cru est placé entre 2 échantillons du film traité et l'assemblage est pressé pendant 6 minutes à 5,6 MPa entre 2 blocs chauffés à 80°C. Ensuite, sur l'assemblage obtenu et découpé en une bande de 25 mm de large, la force de pelage du film a été déterminée avec un appareil AR1000 (Cheminstrument) pendant un pelage se faisant à un angle de 180° et avec une vitesse de 300 mm/min. La valeur du film sans traitement a également été évaluée et est de 4 N/25mm.

Les résultats obtenus sont présentés dans le tableau 3 ci-dessous pour les différents films plastiques utilisés dans cet exemple. Les valeurs « NT » correspondent au film non traité.

**Tableau 3**

| **Film** | **condition** | **Force de pelage (N/25mm)** |
|---|---|---|
| **PET** | NT | 9.5 |
| | Condition 1 | >50 |
| | Condition 2 | 26.8 |
| | Condition 3 | 20.8 |
| | Condition 4 | 20.5 |
| **ETFE** | NT | 3.7 |
| | Condition 1 | >50 |
| | Condition 2 | >50 |
| | Condition 3 | 10.8 |
| | Condition 4 | 18.4 |
| | Condition 5 | >50 |
| | Condition 6 | >50 |
| | Condition 7 | >50 |
| **PI** | NT | 3.6 |
| | Condition 1 | >50 |
| | Condition 2 | 18.7 |
| | Condition 3 | 9.8 |
| | Condition 4 | 8.5 |
| **PEEK** | NT | 3.7 |
| | Condition 1 | >50 |
| | Condition 2 | >50 |
| | Condition 3 | 10.8 |
| | Condition 4 | 18.4 |
| **PEEK** | NT | 5.6 |
| | Condition 1 | >50 |
| | Condition 3 | >50 |
| | Condition 4 | 13.8 |
| **PVDF** | NT | 4 |
| | Condition 1 | Rupture du film |
| | Condition 3 | 12.3 |
| | Condition 4 | 15 |

## Revendications

1. Procédé de traitement d'un film plastique présentant une première surface et une deuxième surface, ledit procédé comprenant une étape de dépôt, dans une enceinte à pression atmosphérique, d'une couche mince sur ladite première surface du film en défilement à une vitesse ***V*,** ledit dépôt étant réalisé par exposition de ladite première surface à un plasma froid dans une atmosphère gazeuse comprenant un gaz plasmagène et au moins un précurseur volatil de silicium, le plasma étant généré avec une densité de puissance dP et ledit au moins un précurseur volatil de silicium étant introduit dans l'enceinte durant l'étape de dépôt avec un débit massique D ;
**caractérisé en ce que** ledit au moins un précurseur volatil de silicium est choisi parmi les alkoxysilanes et les alkoxy-aminosilanes et leurs mélanges ; et **en ce que** le rapport R défini par R = [(V x dP) / D] est compris entre 150 000 et 2 800 000 W.m⁻¹.g⁻¹.

2. Procédé selon la revendication précédente, **caractérisé en ce que** le rapport ***R*** est inférieur ou égal à 2 400 000 W.m⁻¹.g⁻¹, de préférence inférieur ou égal à 2 000 000 W.m⁻¹.g⁻¹.

3. Procédé selon l'une des revendications précédentes, **caractérisé en ce que** le film plastique est fait d'un polymère halogéné, de préférence fluoré.

4. Procédé selon l'une des revendications précédentes, **caractérisé en ce que** ledit au moins un précurseur volatil de silicium est choisi parmi les alkoxy-aminosilanes de formule Si(O(CH₂)ₓCH₃)₃((CH₂)_{y}NH₂) avec x = 1 ; 2 ; 3 ou 4 et y = 1 ; 2 ; 3 ; 4 ou 5.

5. Procédé selon la revendication précédente, **caractérisé en ce que** ledit au moins un précurseur volatil de silicium est le (3-aminopropyl)triéthoxysilane.

6. Procédé selon l'une quelconque des revendications précédentes, **caractérisé en ce que** la vitesse de défilement *V* du film est supérieure à 50 m/min, de préférence supérieure à 80 m/min.

7. Procédé selon l'une des revendications précédentes, **caractérisé en ce que** ledit gaz plasmagène est choisi dans le groupe constitué des gaz nobles, de l'azote et leurs mélanges.

8. Film plastique, susceptible d'être obtenu par le procédé selon l'une quelconque des revendications 1 à 7, notamment fourni en rouleau.

9. Procédé de fabrication d'un composite, comprenant une étape de laminage, notamment à chaud, d'un élastomère avec un film plastique selon la revendication 8 ou obtenu par le procédé selon l'une quelconque des revendications 1 à 7.

10. Composite constitué d'un élastomère recouvert au moins partiellement d'un film plastique selon la revendication 8 ou obtenu par le procédé selon l'une quelconque des revendications 1 à 7 montrant une force de pelage dudit film sur ledit élastomère supérieure à 30 N/25mm, de préférence supérieure à 40 N/25mm.

11. Utilisation d'un film plastique selon la revendication 8 ou obtenu par le procédé selon l'une des revendications 1 à 7 ou d'un composite selon la revendication 10, dans le domaine médical ou pharmaceutique, notamment en tant que produit de scellement ou bouchon ou piston de seringue.

12. Utilisation selon la revendication précédente, **caractérisée en ce que** ledit film plastique est en ETFE ou en PTFE ou en FEP ou en PVDF.

13. Utilisation d'un film plastique selon la revendication 8 ou obtenu par le procédé selon l'une des revendications 1 à 8 ou d'un composite selon la revendication 10, dans un joint, notamment de type torique.

14. Utilisation selon la revendication précédente, **caractérisée en ce que** ledit film plastique est fait d'un polymère du type polymère du type PAEK, et de préférence, de PEEK
